# EUROPEAN PATENT APPLICATION

(11) **EP 1 414 070 A2**
(43) Date of publication of application: **28.04.2004**
(21) Application number: 03256673.9
(22) Date of filing: 23.10.2003
(51) Int. Cl.: H01L 27/146, H01L 31/0232

(54) **Image sensor having concave-shaped micro-lenses**

(30) Priority: 25.10.2002 US 280395
(71) Applicant: Hua Wei Semiconductor (Shanghai) Co., Ltd, Shanghai 200031 (CN)
(72) Inventor: Yamamoto, Katsumi, Shanghai China 200031 (CN)
(74) Representative: Hackney, Nigel John

(57) **Abstract**

An image sensor is disclosed that has a concave micro-lens structure. The image sensor includes a plurality of pixels formed in a semiconductor substrate, each pixel including a light sensitive element. Further, a base material having a first index of refraction is formed over the pixels. Micro-lens cavities are formed in the base material over the light sensitive elements, the micro-lens cavity having a concave shape. Finally, a filler material is formed into the micro-lens cavities, the filler material having a second index of refraction that is higher than the first index of refraction.

## Description

### TECHNICAL FIELD

The present invention relates to image sensors, and more particularly, towards an image sensor that has a concave-shaped micro-lens.

### BACKGROUND

Image sensors are electronic integrated circuits that can be used to produce still or video images. Solid state image sensors can be either of the charge coupled device (CCD) type or the complimentary metal oxide semiconductor (CMOS) type. In either type of image sensor, a light gathering pixel is formed in a substrate and arranged in a two-dimensional array. Modern image sensors typically contain millions of pixels to provide a high resolution image. An important part of the image sensor are the color filters and micro-lens structures formed atop of the pixels. The color filters, as the name implies, are operative, in conjunction with signal processing, to provide a color image. The micro-lenses serve to focus the incident light onto the pixels, and thus to improve the fill factor of each pixel.

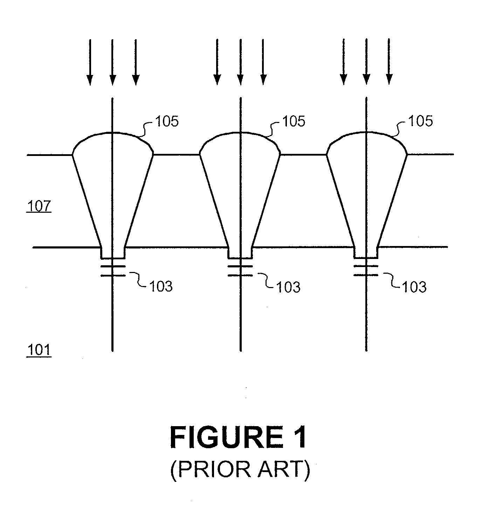

Conventionally, micro-lenses are formed by spin coating a layer of micro-lens material onto a planarized layer. The micro-lens material is then etched to form cylindrical or other shaped regions that are centered above each pixel. Then, the micro-lens material is heated and reflowed to form a convex hemispherical micro-lens. Figure 1 shows a prior art cross-sectional simplified diagram of an image sensor 101 having micro-lenses formed thereon. As seen in Figure 1, the image sensor includes a plurality of pixels that have light detecting elements 103 formed in the substrate. The light detecting elements 103 may be one of several types, such as a photodiode, a photogate, or other solid state light sensitive element. Formed atop of each pixel is a micro-lens 105. The micro-lens 105 focuses incident light onto the light detecting elements 103. Moreover, in the region between the light detecting elements 103 and the micro-lens 105, denoted by reference numeral 107, there are various intervening layers that would typically include the color filter layers and various metal conducting lines. These components are excluded from the diagram in order to simplify the explanation herein and not to obscure the invention.

It has been found that the convex shape of the micro-lenses will sometimes result in a greater likelihood of particle contamination, due to later processing steps. Furthermore, because of the particular processes used to form the micro-lenses, it is difficult to eliminate gaps between the micro-lenses 105. Generally, it is desirable to minimize the gaps between the micro-lenses, since a larger micro-lens will result in a higher degree of light concentration.

Accordingly, in a first aspect, the present invention provides an image sensor according to Claim 1.

### BRIEF DESCRIPTION OF THE DRAWINGS

Figure 1 is a prior art cross sectional view of a portion of an image sensor.
Figure 2 is a top view of an image sensor showing pixels arranged in a two dimensional array and with micro-lenses formed thereon.
Figures 3-9 are cross sectional and corresponding top views of a semiconductor substrate illustrating one method for forming the apparatus of the present invention.
Figure 10 is an isometric view of an apparatus according to one embodiment of the present invention.

### DETAILED DESCRIPTION

The present invention relates to a concave micro-lens structure for use with image sensors, either of the CMOS or CCD type. In the following description, numerous specific details are provided to provide a thorough understanding of the embodiments of the invention. One skilled in the relevant art will recognize, however, that the invention can be practiced without one or more of the specific details, or with other methods, components, etc. In other instances, well-known structures or operations are not shown or described in detail to avoid obscuring aspects of various embodiments of the invention.

Reference throughout the specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout the specification are not necessarily all referring to the same embodiment. Furthermore, the particular features, structures, or characteristics may be combined in any suitable manner in one or more embodiments.

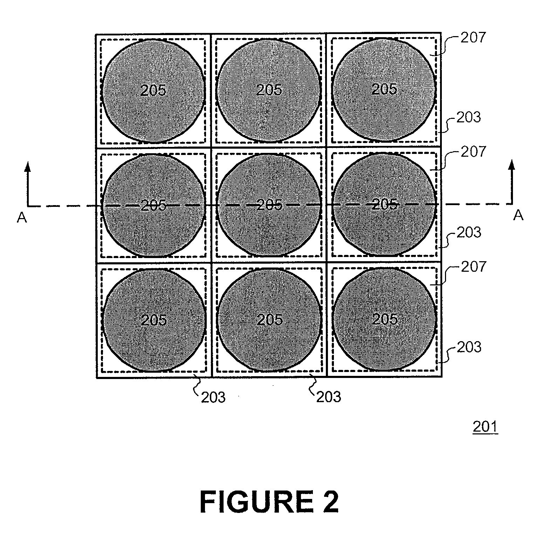

Figure 2 shows a top view of an image sensor 201 formed in accordance with the present invention. The image sensor 201 includes a plurality of pixels 203 typically arranged in a two dimensional array. In the example shown in Figure 2, the image sensor shows a three by three array of pixels 203, though it can be appreciated that an actual mage sensor 201 would have many more pixels, arranged in perhaps over a thousand rows and/or a thousand columns. Further, although Figure 2 shows the pixels in ordered columns and rows, the pixels may be arranged in any type of ordered arrangement. For example, alternating rows may have their pixels slightly offset from each other laterally in a checkerboard format.

The pixels 203 typically include a light sensitive element, such as a photodiode or a photogate as two examples. However, it can be appreciated that other types of light sensitive elements, now known or developed in the future, may be used. Further, the pixels 203 will also include amplification and/or readout circuitry. For clarity, this circuitry is not shown in Figure 2. In one embodiment, the pixels 203 may be active pixels, commonly known in the prior art.

Formed atop of each pixel 203 is a micro-lens 205. The micro-lens 205 is concave in nature, in contrast to the prior art convex micro-lens. Because of the nature of the concave micro-lenses 205, little or no gap exists between adjacent micro-lenses of adjacent pixels.

Additionally, associated with each pixel 203 is a color filter 207. The color filter 207 may be placed either between the micro-lens 205 and the light sensitive element, or alternatively, be formed atop of the micro-lens 205. The color filter 207 is typically a pigmented or dyed material that will only allow a narrow band of light to pass therethrough, for example, red, blue, or green. In other embodiments, the color filter may be cyan, yellow, or magenta. These are but example colors for the color filters 207 and the present invention is meant to encompass a color filter 207 having any color. While the use of pigmented or dyed color materials is the most prevalent form of color filters, other reflective type color filters may be used, such as a multilayer stack reflective material. The formation of color filters 207 is known in art and will not be described herein to avoid any unnecessary obscuration with the description of the present invention. For example, U.S. Patent No. 6,297,071, U.S. Patent No. 6,362,513, and U.S. Patent No. 6,271,900 show the current state of the color filter art.

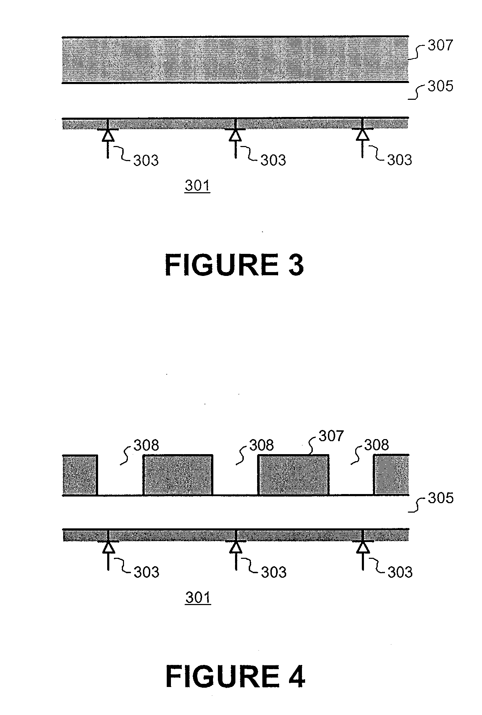

Figures 3-9 are schematic cross sectional and top views of a semiconductor substrate illustrating one method for forming the structure of the present invention. Specifically, Figure 3 is a cross-sectional view taken along line A-A of Figure 2. A semiconductor substrate 301 has a plurality of light sensitive elements 303 (associated with the pixels 203 of Figure 2) formed therein. Figure 3 shows the light sensitive element 303 as a photodiode, though other substitutes and equivalents may be used. Details of forming the photodiode and other associated circuitry are known in the prior art and will not be repeated herein to avoid obscuring the present invention. However, examples of the prior art may be seen in U.S. Patent No. 5,904,493 and U.S. Patent No. 6,320,617.

According to one embodiment, after the pixels 203 are formed in the substrate, an optically transparent (in at least a portion of the visible spectrum) base material 305 is formed over the substrate 301. The base material 305 may be formed using a blanket deposition process, or alternatively, using a spin on method. In one embodiment, the base material is an epoxy or an acrylic. These materials are chosen because of their stability, each of handling, or appropriate index of refraction. As will be seen below, it is important that the base material have a relatively low index of refraction. For an epoxy or acrylic material, the index of refraction is in the 1.4 to 1.5 range. One example of a suitable material is polymethylmethacrylate (PMMA) or polyglycidylmethacrylate (PGMA). Alternatively, the base material may be an oxide.

While specific examples are given above, it can be appreciated that the base material may be formed from any optically transparent material having a relatively low index of refraction. In the case where the base material 305 is applied using spin on techniques, the base material 305 has the advantage of being substantially planar. It is desirable to have the base material 305 have a top surface that is as planar and smooth as possible. Nevertheless, a blanket deposition, such as by chemical vapor deposition, may also be suitable.

In one embodiment, the thickness of the base material 305 is on the order of 2 to 2.5 microns. However, thinner or thicker layers of the base material 305 may also be used, depending on various design parameters, such as desired focal length of the micro-lens.

Still referring to Figure 3, after the base material 305 has been deposited, a resin layer 307 is deposited. The resin layer 307 is also referred to as a sacrificial layer, and in one embodiment, is a phenyl resin. Because the resin layer 307 will be used as a sacrificial layer, again, there is some flexibility in the precise material used for the resin layer 307.

In one embodiment, the resin layer 307 will need to be patterned. Because of this, it is efficient to use a photoresist type material (such as a phenyl resin) as the resin layer 307. In that way, the resin layer 307 can be "directly patterned" by simply the use of a photolithography apparatus and a developing process.

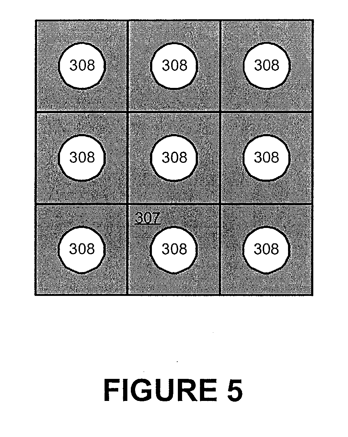

Turning next to Figure 4, the resin layer 307 is patterned and developed to remove portions 308 of the resin layer 307. The portions 308 of the resin layer 307 that are removed are generally over the light sensitive elements 303 and are circular in shape. A top view of the resin layer 307 showing portions removed is shown in Figure 5. The removed portions 308 of the resin layer 307 is related to the concave micro-lens to be eventually formed. Again, the specific shape and dimensions of the removed portions shown in Figures 4 and 5 is but one specific embodiment of the present invention. Other specific implementations are possible. For example, the size of the portions 308 shown in Figures 4 and 5 may be made smaller or larger depending upon the desired size of the micro-lenses to be formed. A larger size for the portion 308 will result in a larger micro-lens, and vice versa.

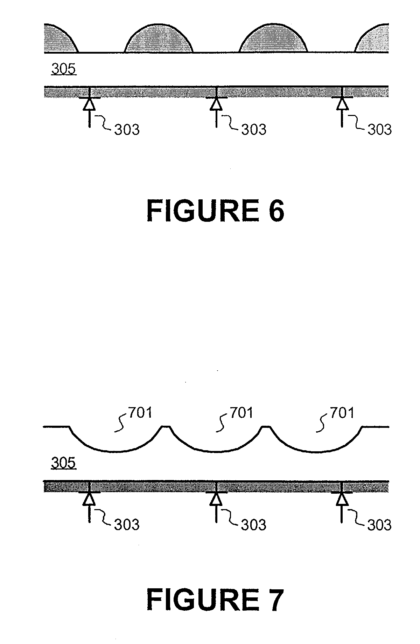

Turning to Figure 6, once the resin layer 307 has been developed (in the case of the resin layer 307 being a photoresist) or etched (in the case of a non-photoresist sacrificial layer), the remaining portions of the resin layer 307 are heated to a reflow temperature. This causes the resin layer 307 to adopt a minimum surface tension shape, which in many cases results in a spherical shape, as shown in Figure 6.

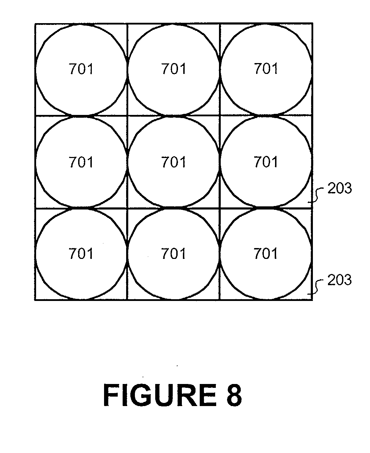

Once the reflow process has been finished, an anisotropic dry etch is performed using the reflowed resin layer 307 as an etching mask. In one embodiment, the etch is a reactive ion etch using O₂ as the primary gas and CH₃ as a secondary gas. In one embodiment, the etching ratio between the base material 305 and the resin layer 307 is on the order of 1.0 to 1.5. Thus, the underlying base material 305 is etched faster than the resin layer 307. In one embodiment, the etching process is complete when the resin layer 307 is removed. Because of the reflowed shape of the resin layer 307, the result of the dry etch is a hemispherical "pitting" of the base material 305 to form a concave micro-lens 701 over each light sensitive element 303. The result is seen if Figure 7 (cross-section) and Figure 8 (top view).

It should be noted that the spacing between adjacent micro-lenses can be varied by controlling the spacing of the removed portions 308 formed in the resin layer 307. Small removed portions 308 that are spaced far apart from each other will result in relatively small micro-lenses and large gaps between the resultant micro-lenses. Large removed portions 308 will result in large resultant micro-lenses with small gaps. Moreover, by employing over-etching techniques during etching of the base material 305 and the resin layer 307, the gaps between adjacent micro-lenses can be reduced to zero. It can be appreciated that the size of the removed portions 308, the etching length, the composition of the base material 305 and resin layer 307, and other process/design factors can be varied to achieve the desired result for the characteristics of the micro-lenses.

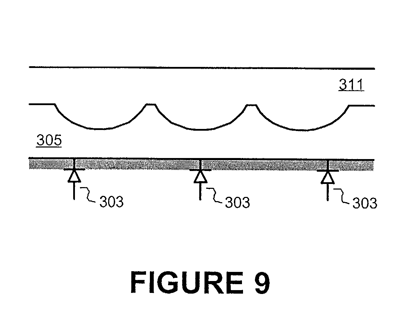

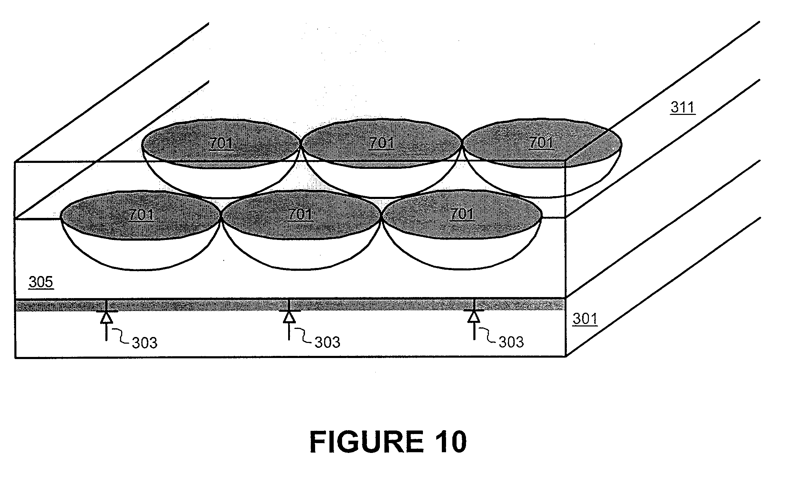

Finally, turning to Figure 9, a fill material 311 is formed over the base material 305 and micro-lens 701. The fill material 311 should have a relatively high index refraction that is higher than the base material 305 such that bending and focusing of incident light onto the light sensitive elements 303 takes place. In one embodiment, the fill material 311 has an index of refraction of between 1.6 and 1.8. One example of the fill material 311 is an optically transparent polyimide. n one embodiment, the thickness of the polyimide layer 311 is on the order of 3 to 4 microns. The polyimide layer 311 is typically applied using spin coating. An isometric view of the completed structure in shown in Figure 10.

According to the present invention, a minimal spacing between micro-lenses can be more easily achieved. This improves the fill factor and efficiency in gathering light, thereby improving the sensitivity. Also, the concave shape of the micro-lenses provides advantages in available packaging techniques, which in turn can minimize particles and dust from interfering with the image sensor. Further, according to the present invention, the color filters can be formed using conventional methods either on top of the micro-lenses or in between the micro-lenses and the light sensitive elements 303. Moreover, the use of a concave shaped micro-lens results in a relatively short focal length. This in turn allows for higher integration densities.

From the foregoing, it will be appreciated that specific embodiments of the invention have been described herein for purposes of illustration, but that various modifications may be made without deviating from the spirit and scope of the invention. Thus, regardless of the specific materials used, the present invention teaches the use of concave micro-lenses that are filled with the appropriate material to focus incident light. Accordingly, the invention is not limited except as by the appended claims.

## Claims

1. An image sensor comprising:
a plurality of pixels formed in a semiconductor substrate, each pixel including a light sensitive element;
a base material formed over said plurality of pixels, said base material having a first index of refraction;
a micro-lens cavity formed in said base material over said light sensitive element, said micro-lens cavity having a concave shape; and
a filler material formed into said micro-lens cavity, said filler material having a second index of refraction that is higher than said first index of refraction.

2. The image sensor of Claim 1 further including a color filter formed over each pixel, said color filter formed between said micro-lens and said light sensitive element.

3. The image sensor of Claim 1 further including a color filter formed over each pixel, said color filter formed over said micro-lens.

4. The image sensor of Claim 1 wherein the base material is an epoxy or acrylate material.

5. The image sensor of Claim 1 wherein said filler material is a phenyl resin.

6. The image sensor of Claim 1 wherein said base material is either polymethylmethacrylate (PMMA) or polyglycidylmethacrylate (PGMA).

7. A pixel of an image sensor comprising:
a light sensitive element formed in a semiconductor substrate;
a base material formed over said light sensitive element, said base material having a first index of refraction;
a micro-lens cavity formed in said base material over said light sensitive element, said micro-lens cavity having a concave shape; and
a filler material formed into said micro-lens cavity, said filler material having a second index of refraction that is higher than said first index of refraction.

8. The pixel of Claim 7 further including a color filter formed over said light sensitive element, said color filter formed between said micro-lens and said light sensitive element.

9. The pixel of Claim 7 further including a color filter formed over said light sensitive element, said color filter formed over said micro-lens.

10. The pixel of Claim 7 wherein the base material is an epoxy or acrylate material.

11. The pixel of Claim 7 wherein said filler material is a phenyl resin.

12. The pixel of Claim 7 wherein said base material is either polymethylmethacrylate (PMMA) or polyglycidylmethacrylate (PGMA).

13. A micro-lens for use over a pixel of an image sensor comprising:
a base material formed over said pixel, said base material having a first index of refraction;
a micro-lens cavity formed in said base material over said light sensitive element, said micro-lens cavity having a concave shape; and
a filler material formed into said micro-lens cavity, said filler material having a second index of refraction that is higher than said first index of refraction.

14. The micro-lens of Claim 13 further including a color filter formed over said light sensitive element, said color filter formed between said micro-lens and said light sensitive element.

15. The micro-lens of Claim 13 further including a color filter formed over said light sensitive element, said color filter formed over said micro-lens.

16. The micro-lens of Claim 13 wherein the base material is an epoxy or acrylate material.

17. The micro-lens of Claim 13 wherein said filler material is a phenyl resin.

18. The micro-lens of Claim 13 wherein said base material is either polymethylmethacrylate (PMMA) or polyglycidylmethacrylate (PGMA).
